(19) Europäisches Patentamt
European Patent Office
Office européen des brevets

(11) Numéro de publication : **0 016 679**
**B1**

(12) # FASCICULE DE BREVET EUROPÉEN

(45) Date de publication du fascicule du brevet : 09.06.82

(51) Int. Cl.$^3$ : G 03 C 1/72, G 03 F 7/10, C 08 F220/22

(21) Numéro de dépôt : 80400300.2

(22) Date de dépôt : 04.03.80

(54) **Substances de photomasquage, leur procédé de préparation, et masque obtenu.**

(30) Priorité : 09.03.79 FR 7906136
17.07.79 FR 7918467

(43) Date de publication de la demande : 01.10.80 (Bulletin 80/20)

(45) Mention de la délivrance du brevet : 09.06.82 Bulletin 82/23

(84) Etats contractants désignés : DE GB IT

(56) Documents cités :
DE A 2 743 763
FR A 2 299 665
FR A 2 339 184
FR A 2 389 156
GB A 780 218
US A 4 061 829

J. ELECTROCHEM. SOC. : SOLID STATE SCIENCE AND TECHNOLOGY, vol. 124, no. 10, octobre 1977 Princeton N.J. US M. KAKUCHI et al. : «Poly (fluoro methacrylate) as highly sensitive high contrast positive resist» pages 1648-1651.

JOURNAL OF APPLIED POLYMER SCIENCE vol. 21, 1977 New York US J.N. HELBERT et al. : « Radiation degradation of alpha-substituted acrylate polymers and copolymers », pages 797-807.

(73) Titulaire : THOMSON-CSF
173, Boulevard Haussmann
F-75360 Paris Cedex 08 (FR)

(72) Inventeur : Eranian, Armand
"THOMSON-CSF" SCPI-173, bld Haussmann
F-75360 Paris Cedex 08 (FR)
Inventeur : Dubois, Jean-Claude
"THOMSON-CSF" SCPI-173, bld Haussmann
F-75360 Paris Cedex 08 (FR)
Inventeur : Couttet, André
"THOMSON CSF" SCPI-173, bld Haussmann
F-75360 Paris Cedex 08 (FR)
Inventeur : Datamanti, Evelyne
"THOMSON-CSF" SCPI-173, bld Haussmann
F-75360 Paris Cedex 08 (FR)

(74) Mandataire : Wang, Pierre et al
THOMSON-CSF SCPI 173, Bld Haussmann
F-75360 Paris Cedex 08 (FR)

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

EP 0 016 679 B1

Imprimerie Jouve, 18, rue St-Denis, 75001 Paris, France

Substances de photomasquage, leur procédé de préparation, et masque obtenu

La présente invention concerne de nouvelles compositions de résines ou polymères, utilisées comme produits de masquage dans la réalisation des masques de fabrication en microélectronique ou en optique intégrée par exemple. Bien que ces résines et les masques obtenus soient dénommés de façon générique « photorésists », l'invention concerne des compositions dégradables non seulement par les faisceaux de photons (rayons γ, X, ultraviolets lointains) mais aussi par les faisceaux d'électrons.

La nécessité d'intégrer davantage de composants sur un même substrat entraîne la nécessité de diminuer les dimensions des motifs représentés sur les masques, car les dimensions du substrat monocristallin ne peuvent pas être beaucoup augmentées, pour des raisons de cristallographie et de dissipation thermique qui sortent du domaine de l'invention.

Cependant, la réalisation de masques à haute résolution n'est plus possible avec la lumière visible, dont la longueur d'onde est trop importante, ce qui entraîne des phénomènes de diffraction sur les bords des motifs des masques, et donc une mauvaise définition. C'est pourquoi il est nécessaire d'utiliser pour l'irradiation des produits de masquage des rayonnements à plus haute définition, tels que les faisceaux de rayons γ, X et ultraviolets lointains ou les faisceaux d'électrons qui, eux, permettent d'obtenir des masques à haute résolution, ayant donc une grande précision dans la finesse des traits — n'excédant pas le micron en largeur.

L'adaptation à un nouveau rayonnement entraîne pour les produits de masquage une adaptation de leur sensibilité à ces rayonnements.

Par ailleurs, il existe deux types de produits de masquage. Les résines « positives » sont dégradées par le rayonnement, tandis que les résines « négatives » sont réticulées : ceci signifie qu'après exposition, un solvant approprié dissout les parties des résines positives qui ont été exposées au rayonnement, mais, au contraire dissout les parties des résines négatives qui n'ont pas été exposées au rayonnement. En fait, les résines positives sont davantage utilisées, pour obtenir une haute résolution car leur contraste est, d'une façon générale, supérieur à celui des résines négatives.

L'invention concerne donc des substances polymères, dégradables sous l'action des photons et des électrons, ainsi que leur procédé de fabrication.

Des compositions polymères positives, sensibles aux photons et aux électrons, sont connues, tel le polyméthacrylate de méthyle, mais leur sensibilité aux différents types de rayonnement photonique et électronique est variable et dépend de l'énergie correspondante absorbée.

Par exemple, en ce qui concerne l'action des rayons X, les substances polymères, objet de l'invention, sont plus sensibles, dans un plus large domaine de longueurs d'onde, car leur structure comporte une pluralité d'atomes halogénés qui absorbent l'énergie de façon sélective dans une pluralité de domaines spectraux, se complétant ainsi entre eux.

De façon plus précise, l'invention est constituée par une substance de photomasquage, dégradable sous l'action d'un rayonnement, caractérisée en ce qu'elle est constituée de copolymères de type α-alkylacrylique substitués par au moins deux types d'atomes d'halogènes, de formule générale

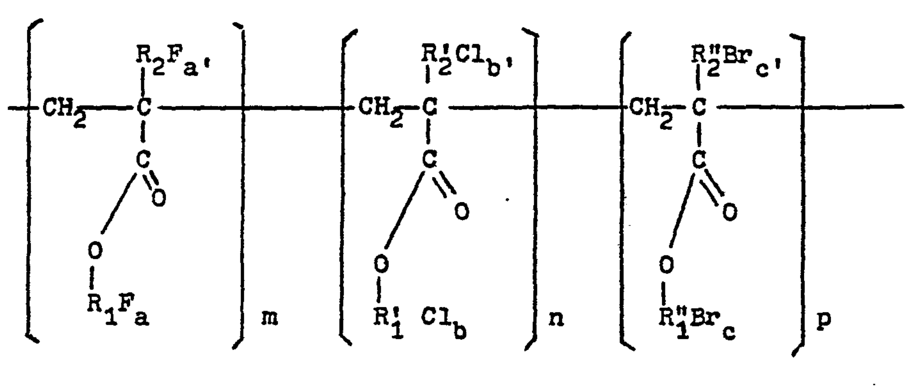

dans laquelle

$R_1$, $R_1'$, $R_1''$, $R_2$, $R_2'$, $R_2''$ désignent des radicaux alkyle dont la chaîne principale contient de 1 à 10 atomes de carbone ; ces radicaux étant substitués par du fluor, du chlore, du brome dont les indices a, a', b, b', c, c' sont des nombres entiers, positifs ou nuls ;

m, n, p désignent des nombres entiers, égaux ou supérieurs à zéro, un seul parmi les trois nombres m, n, p pouvant être égal à zéro.

L'invention sera mieux comprise grâce à la description qui suit, laquelle s'appuie sur la figure jointe qui représente la variation du coefficient massique d'adsorption avec la longueur d'onde.

La figure unique représente la courbe typique de variation avec la longueur d'onde λ, du coefficient massique d'absorption du rayonnement X par un atome. Le coefficient massique d'absorption pour un atome est exprimé pour chaque branche par la relation :

$$\mu/\rho = C\, Z^3\, \lambda^3$$

dans laquelle

μ est le coefficient linéaire d'absorption des X

ρ est la masse volumique

C est une constante

Z est le nombre atomique

λ est la longueur d'onde.

Cette relation montre que l'absorption est proportionnelle aux cubes du nombre atomique et de la longueur d'onde, mais la figure 1 montre que la courbe de variation est en dent de scie, composée de plusieurs branches. Chaque branche de la courbe correspond à un domaine d'absorption, qui est connu sous les dénominations de branches K, L, M. Ainsi, il apparaît que pour un atome, l'absorption à une longueur d'onde n'est pas automatiquement plus importante qu'à une longueur d'onde inférieure, ce qui fait perdre le bénéfice de la puissance cubique de la longueur d'onde. C'est le cas en particulier, au voisinage des discontinuités entre les différentes branches.

De plus, en ce qui concerne l'absorption du rayonnement X par une molécule telle qu'un polymère, en particulier du rayonnement X mou (par exemple $0{,}4 < \lambda < 5$ nm) celle-ci apparaît comme une somme pondérée des contributions individuelles de chaque atome constitutif du polymère.

Or, la plupart des polymères usuels, en particulier le polyméthacrylate de méthyle, sont constitués d'éléments légers comme le carbone, l'oxygène et l'hydrogène. Il en résulte qu'ils absorbent le rayonnement X de façon peu intense, d'où une sensibilité relativement faible.

Le brevet français n° 2.339.184 révèle une nouvelle famille de polymères dégradables sous l'action des photons et des électrons avec une sensibilité et un contraste plus élevés que ceux du polyméthacrylate de méthyle. Il s'agit de polyméthacrylates halogénés, en particulier fluorés, sur le radical ester. L'augmentation de sensibilité à certaines longueurs d'onde, est imputable à la présence des atomes de fluor plus absorbants que le carbone et l'oxygène à ces longueurs d'onde.

Cette solution présente néanmoins un inconvénient majeur. Du fait de l'existence des discontinuités d'absorption qui se traduisent par une chute brutale de l'absorption, il s'avère que le fluor n'est pas intéressant dans toute la gamme des rayons X mous comprise entre 0,4 et 5 nm, en particulier juste après le passage de sa discontinuité d'absorption K à 17,9 nm, comme le montre le tableau 1, ci-dessous :

Tableau 1

| Halogène | $\lambda_K$ $10^{-1}$ nm | $\lambda_{L_I}$ $10^{-1}$ nm | $\lambda L_{II}$ $10^{-1}$ nm | $\lambda L_{III}$ $10^{-1}$ nm | $\lambda M_I$ $10^{-1}$ nm |
|---|---|---|---|---|---|
| Fluor | 17,9 | — | — | — | — |
| Chlore | 4,4 | 52,1 | 61,4 | 61,7 | 417,8 |
| Brome | 0,9 | 6,9 | 7,8 | 8,0 | 47,9 |

L'incorporation, au niveau d'un même radical ester, de chlore ou de brome en plus du fluor, pour remédier à cet état de chose, est limitée par l'encombrement stérique de ces atomes.

Le tableau 1, cependant, met en évidence l'intérêt des atomes halogènes, en particulier du chlore et du brome, lesquels absorbent les rayons X, l'absorption à une longueur d'onde par un atome masquant la discontinuité d'absorption à cette même longueur d'onde d'un autre atome.

Il est donc intéressant d'associer plusieurs atomes halogènes dans une même molécule polymère, la discontinuité d'absorption d'un atome, à une longueur d'onde, étant compensée par l'absorption des autres atomes, à la même longueur d'onde. L'encombrement stérique des halogènes ne permettant pas de fixer plusieurs halogènes sur un même radical, la composition objet de l'invention est un co- ou terpolymère, obtenu à partir d'au moins deux parmi trois monomères dont le premier comporte au moins un radical fluoré, le second au moins un radical chloré et le troisième au moins un radical bromé.

La substance sensible aux radiations objet de l'invention est donc un polymère à base d'alkylacrylate de formule générale :

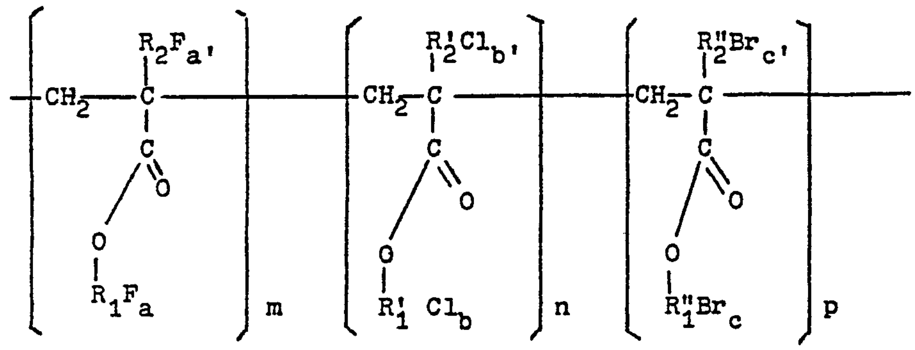

Si un seul des nombres m, n, p est égal à zéro, la composition est un copolymère.

Si aucun des nombres m, n, p n'est égal à zéro, la composition est un terpolymère.

L'intérêt de telles compositions est double :

D'une part, la présence d'atomes d'halogènes entraîne une augmentation de sensibilité au rayonnement X mou (0,4-5 nm) par rapport aux polymères positifs classiques comme le polyméthacrylate de méthyle. Ceci est imputable au pouvoir absorbant des halogènes qui est supérieur à celui de l'hydrogène, du carbone et de l'oxygène, comme le montre le tableau 2, qui donne les coefficients massiques d'absorption de ces corps, en comparaison de ceux des halogènes, pour différentes longueurs d'onde (sur ce tableau figurent également, pour chaque raie d'émission, la nature de l'anticathode qui l'a produite, et la dénomination de la raie : anticathode d'aluminium, raie $K_{\alpha 1,2}$ à 0,8 34 nm.

Tableau 2

| $\frac{\mu}{\rho}$ (cm²/g) | H | C | O | F | Cl | Br |
|---|---|---|---|---|---|---|
| $4{,}37.10^{-1}$ nm (Pd, $L_{\alpha 1}$) | — | 97,5 | 235,6 | 338,1 | 1 906 | 1 541 |
| $5{,}41.10^{-1}$ nm (Mo, $L_{\alpha 1}$) | — | 182 | 439,5 | 630,7 | 292,5 | 2 741 |
| $8{,}34.10^{-1}$ nm (Al, $K_{\alpha 1,2}$) | 1,8 | 718,4 | 1 597 | 2 037 | 1 023 | 1 021 |
| $13{,}3\ .10^{-1}$ nm (Cu, $L_{\alpha 1,2}$) | 8,9 | 2 714 | 5 601 | 6 941 | 3 596 | 3 101 |
| $16{,}0\ .10^{-1}$ nm (Co, $L_{\alpha 1,2}$) | 16 | 4 451 | 8 877 | 10 910 | 5 750 | 4 671 |
| $21{,}6\ .10^{-1}$ nm (Cr, $L_{\alpha 1,2}$) | 43,4 | 9 902 | 18 740 | 1 344 | 12 100 | 8 955 |
| $27{,}4\ .10^{-1}$ nm (Ti, $L_{\alpha 1,2}$) | 96,7 | 17 960 | 1 756 | 2 490 | 20 570 | 14 360 |
| $44{,}7\ .10^{-1}$ nm (C, Kα) | 472,7 | 2 373 | 6 044 | 8 730 | 50 760 | 32 550 |

D'autre part, la nature d'interpolymères — copolymères ou terpolymères — de ces résines permet d'étendre la gamme spectrale de sensibilisation au voisinage des discontinuités d'absorption de chacun des halogènes, en particulier de celles situées dans le domaine de longueur d'onde compris entre 0,4 et 5 nm.

En plus de leur sensibilité élevée, ces résines jouissent de bonnes propriétés d'enduction et d'une adhérence notable, ce qui favorise leur mise en œuvre pour la réalisation de masques à haute définition.

Premier exemple de synthèse

Les substances halogénées sont préparées par copolymérisation ou terpolymérisation de monomères mono- ou poly- fluorés, chlorés, bromés. Sont particulièrement intéressants comme monomères, ceux dont le radical est éthylmonohalogéné :

méthacrylate de fluoro-2 éthyle

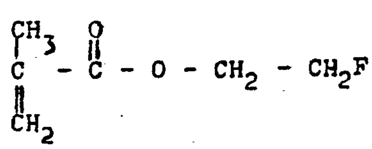

méthacrylate de chloro-2 éthyle

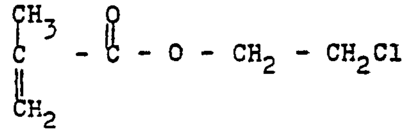

méthacrylate de brome-2 éthyle

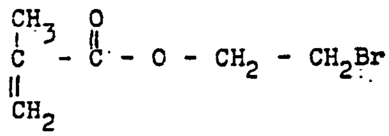

Leur synthèse est effectuée soit par estérification directe de l'acide méthacrylique par l'alcool halogéné correspondant, soit par acylation de cet alcool par le chlorure de méthacryloyle, c'est-à-dire soit :

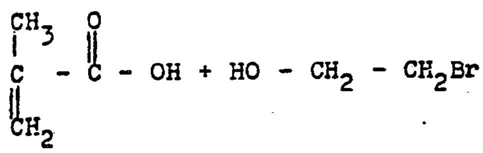

soit :

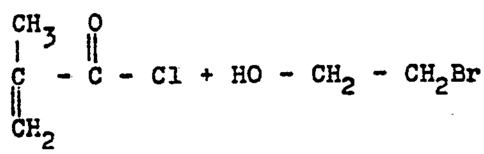

Br pouvant être remplacé par F ou Cl, selon le type de dérivé halogéné qui est souhaité.

L'élaboration des interpolymères est ensuite mise en œuvre en mélangeant ces monomères dans un solvant adéquat, par exemple le benzène. Un catalyseur de polymérisation radicalaire est ajouté : le peroxyde de benzoyle. Le mélange est chauffé à 80 °C pendant 48 heures. Après refroidissement, les copolymères ou terpolymères sont isolés par précipitation dans du méthanol.

D'autres catalyseurs de polymérisation radicalaire sont utilisables : le 2,2-azo-bis-(isobutyronitrile)

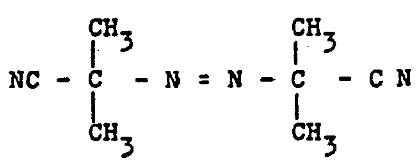

donne d'excellents résultats.

Exemple de synthèse appliquée

Cet exemple est relatif à la copolymérisation du méthacrylate de fluoro-2 éthyle et du méthacrylate de chloro-2 éthyle en proportion molaire relative 1/1.

On dissout 0,018 g (0,05 % de la masse totale) de peroxyde de benzoyle dans une solution de benzène (21,9 g soit 25 $cm^3$) contenant 6,6 g (0,05 mole) de méthacrylate de fluoro-2-éthyle et 7,42 g (0,05 mole) de méthacrylate de chloro-2 éthyle, tous deux préalablement distillés. La solution est chauffée à reflux de la masse réactionnelle pendant 48 heures. Après refroidissement, elle est diluée avec 50 $cm^3$ d'acétone puis coulée dans du méthanol (2 litres). Le copolymère qui précipite est recueilli par filtration, lavé au méthanol puis séché sous vide pendant 96 heures. On obtient 9,3 g de produit sec représentant ainsi un taux de transformation de 66,3 %.

Second exemple de synthèse

La substance est préparée par copolymérisation ou terpolymérisation des α-(halogénoalkyl) acrylates d'alkyle ou d'halogénoalkyle.

Parmi les α-(halogénoalkyl) acrylates intéressants, on peut citer :

— l'α-(bromométhyl) acrylate d'éthyle

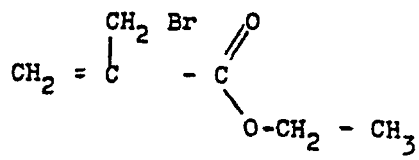

— l'α-(fluorométhyl) acrylate d'éthyle

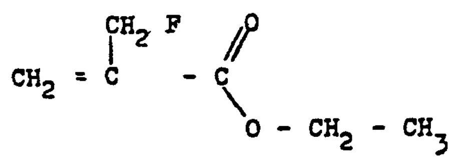

— l'α-(chlorométhyl) acrylate d'éthyle

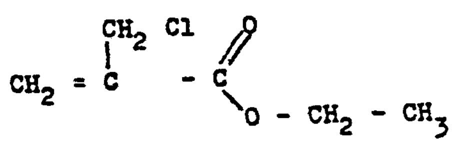

La synthèse de ces monomères met en jeu plusieurs étapes qui apparaissent sur le schéma réactionnel reproduit au tableau 3. Il est à noter que les substances fluoré et chloré s'obtiennent à partir du monomère bromé.

(voir Tableau 3 page 7)

Tableau 3

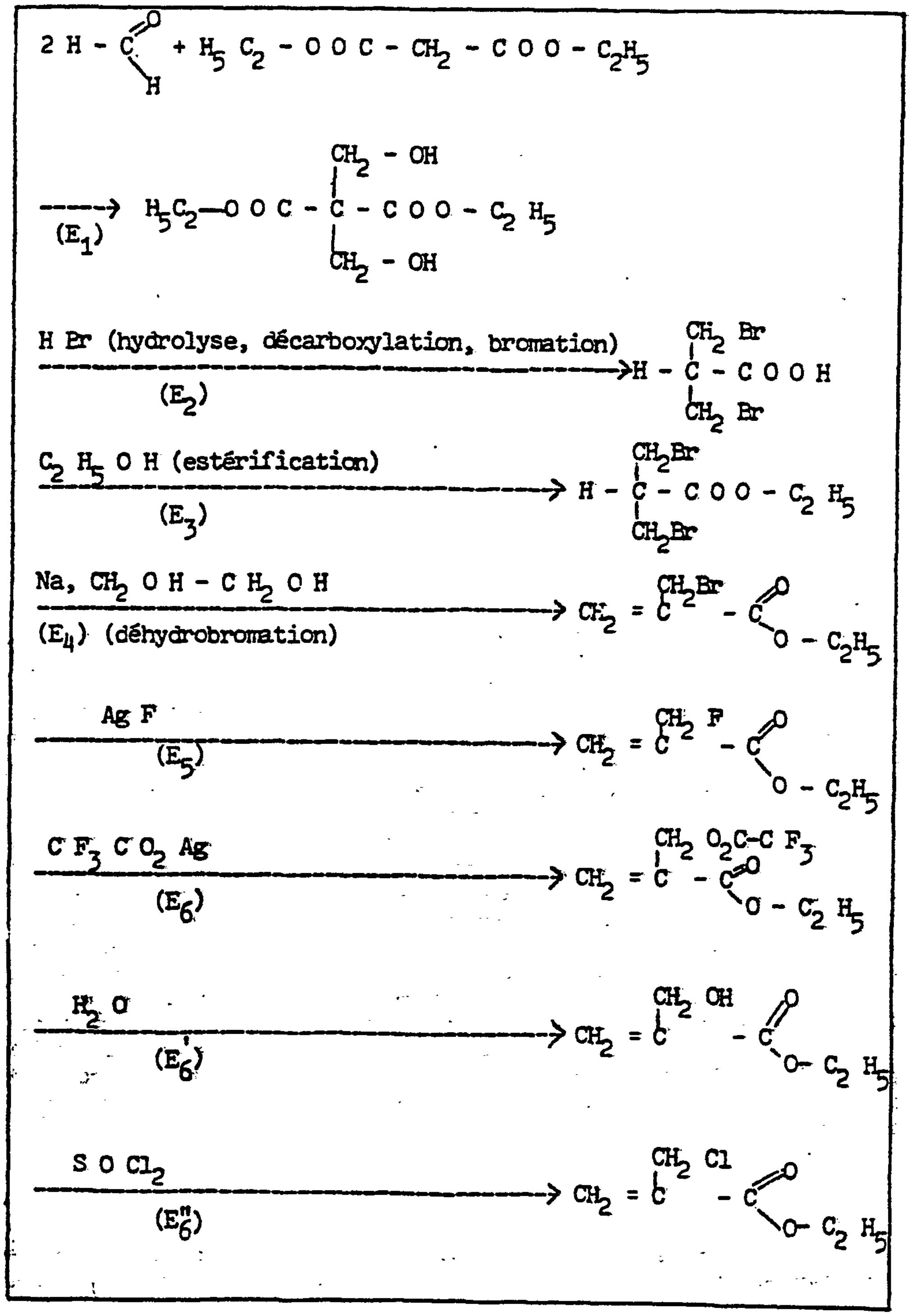
(E1)
H Br (hydrolyse, décarboxylation, bromation)
(E2)
C2 H5 O H (estérification)
(E3)
Na, CH2 O H - C H2 O H
(E4) (déhydrobromation)
Ag F
(E5)
C F3 C O2 Ag
(E6)
H2 O
(E'6)
S O Cl2
(E"6)

Les étapes $E_1$ à $E_4$ pour la synthèse du monomère bromé, consistent à :

($E_1$) : préparer du bis (hydroxyméthyl) malonate de diéthyle par condensation du formol et du malonate de diéthyle ;

($E_2$) : former l'acide β, β'-dibromoisobutyrique par action de H Br sur le bis-(hydroxyméthyl) malonate de diéthyle ;

($E_3$) : estérifier l'acide par de l'éthanol pour former du β, β'-dibromoidobutyrate d'éthyle ;

($E_4$) : déhydrobromer l'ester ainsi obtenu par de l'éthylène glycolate de sodium entraînant la formation d'α-(bromométhyl) acrylate d'éthyle.

L'étape $E_5$, pour le monomère fluoré consiste à substituer du fluor au brome par action du fluorure d'argent, entraînant la formation d'α-(fluorométhyl) acrylate d'éthyle.

Les étapes $E_6$, $E_6'$, $E_6''$ pour le monomère chloré consistent à :

($E_6$) : faire agir du trifluoroacétate d'argent sur l'α-(bromométhyl) acrylate d'éthyle, entraînant la formation d'α-(trifluoroacétoxyméthyl) acrylate d'éthyle :

($E_6'$) : hydrolyser ce composé d'où formation d'α-(hydroxyméthyl) acrylate d'éthyle ;

($E_6''$) : faire agir du chlorure de thionyle sur l'α-(hydroxyméthyl) acrylate d'éthyle pour former l'α-(chlorométhyl) acrylate d'éthyle.

L'obtention, à partir de ces monomères, de monomères halogénés de surcroît sur le radical ester est réalisé par transestérification à partir des alcools halogénés correspondants en utilisant des catalyseurs habituels dans une réaction de ce type.

La copolymérisation ou la terpolymérisation de ces monomères est ensuite réalisée en les mélangeant dans un solvant adéquat, par exemple le benzène. Un catalyseur de polymérisation radicalaire est ajouté : le peroxyde de benzoyle. Ce mélange est chauffé à 80 °C pendant 48 heures. Après refroidissement, on isole les polymères formés par précipitation dans un non-solvant, par exemple le méthanol.

D'autres catalyseurs de polymérisation radicalaire sont utilisables, par exemple le 2,2 azo-bis-isobutyronitrile.

## Exemple de synthèse appliquée

L'exemple de synthèse ci-après est relatif à l'élaboration d'un copolymère de l'α-(fluorométhyl) acrylate d'éthyle et de l'α-(bromométhyl) acrylate d'éthyle en proportion molaire relative 1/1.

0,019 g (0,05 % de la masse totale) de peroxyde de benzoyle sont dissous dans une solution de benzène (21,9 g soit 25 $cm^3$) contenant 6,6 g (0,05 mole) d'α-(fluorométhyl) acrylate d'éthyle et 9,65 g (0,05 mole) d'α-(bromométhyl) acrylate d'éthyle, tous deux préalablement distillés. La solution est chauffée à reflux de la masse réactionnelle pendant 48 heures. Après refroidissement, elle est diluée avec 50 $cm^3$ d'acétone puis coulée dans du méthanol (2 litres). Le copolymère, qui précipite, est recueilli par filtration, lavé au méthanol puis séché sous vide pendant 96 heures. La masse de produit sec obtenue correspond à un taux de transformation de l'ordre de 50 %.

Le procédé d'utilisation des compositions selon l'invention est particulièrement simple, et conforme aux normes de l'homme de l'art. Lorsqu'elles sont utilisées en tant que matériau de transfert d'image, elles sont dissoutes dans un solvant du type méthyl-4 pentanone-2, puis ensuite déposées en couche mince, typiquement 0,5 à 1 μm, par centrifugation sur un substrat, tel qu'une tranche de silicium.

Après chauffage à une température optimale, destiné à éliminer le solvant résiduel et à augmenter l'adhérence des couches, les échantillons sont irradiés en vue de provoquer des scissions de chaînes, donc de rendre ces résines plus solubles dans un mélange de révélation approprié.

Différents rayonnements sont utilisables, aussi bien de type électronique que photonique : rayonnement γ émis par exemple par des sources classiques telles que $^{137}_{55}Cs$ ou $^{60}_{27}Co$ ; rayonnement ultraviolet « lointain » ($200 < \lambda < 300$ nm) ; rayonnement X, en particulier le rayonnement X « mou » $0,4 < \lambda < 5$ nm) soit continu (rayonnement synchrotron dans un anneau de stockage) soit provenant de l'émission de raies caractéristiques.

## Premier exemple d'utilisation

Cet exemple rend compte de l'utilisation du copolymère cité précédemment : méthacrylate de fluoro-2 éthyle méthacrylate de chloro-2 éthyle en tant que matériau de masquage lors d'une irradiation par des rayons X mous.

Cette substance est dissoute dans le méthyl-4 pentanone-2 (MIBC) de façon à obtenir une solution à 10 % en poids. Une tranche de silicium est ensuite enduite, par centrifugation, d'un film de résine.

Avec une vitesse de rotation de 3 500 t/min, on obtient un film d'environ 0,5 μm d'épaisseur. L'échantillon est recuit à 180 °C pendant 30 minutes pour éliminer le solvant résiduel. Il est alors irradié sous vide par des rayons X de 0,8 34 nm de longueur d'onde (anticathode d'Al) à travers un masque. La durée de l'irradiation est optimisée de façon à obtenir la dissolution totale de la couche de résine dans les zones irradiées, après révélation dans le mélange MIBC (1 partie en volume) isopropanol (1 partie en volume), 1 minute à 30 °C.

Second exemple d'utilisation

L'exemple d'utilisation ci-après rend compte de l'utilisation du copolymère cité précédemment : α-(fluorométhyl) acrylte d'éthyle-α(bromométhyl) acrylate d'éthyle en tant que matériau de masquage lors d'une irradiation par des rayons X mous. Ce copolymère est dissous à 15 % en poids à partir duquel il est déposé en film mince (0,5 µm d'épaisseur) par centrifugation sur une pastille de silicium oxydé en surface.

La pastille recouverte du film mince est recuite à 180 °C pendant 30 minutes pour éliminer le solvant résiduel. Elle est alors irradiée sous vide par des rayons X de 2,1 6 nm de longueur d'onde (anticathode de Cr) à travers un masque. La durée de l'irradiation est « optimisée » de façon à obtenir la dissolution totale de la couche de résine dans les zones irradiées après révélation.

De façon plus générale, les masques de fabrication obtenus à l'aide d'une telle composition dégradable sous l'action d'un rayonnement, font partie de l'invention.

De tels masques sont utilisés en microélectronique, pour la fabrication de composants électroniques, notamment de circuits intégrés.

Ils peuvent également être utilisés en optique intégrée, pour la fabrication de composants optoélectroniques.

**Revendications**

1. Substance de photomasquage, dégradable sous l'action d'un rayonnement, caractérisée en ce qu'elle est constituée de copolymères de type α-alkylacrylique substitués par au moins deux types d'atomes d'halogènes, de formule générale

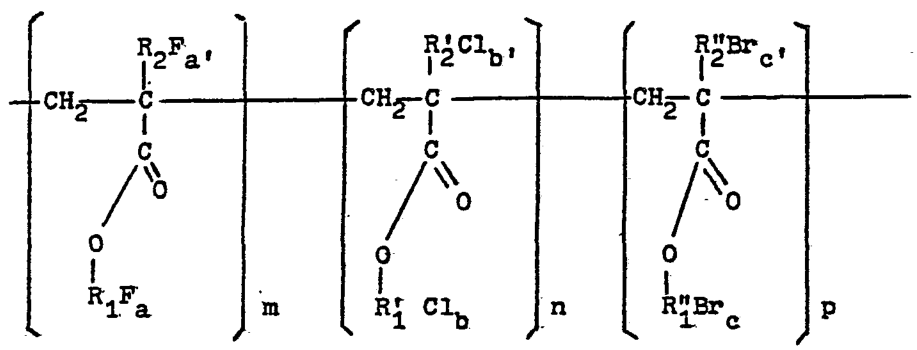

dans laquelle

$R_1$, $R'_1$, $R''_1$, $R_2$, $R'_2$, $R''_2$ désignent des radicaux alkyle dont la chaîne principale contient de 1 à 10 atomes de carbone ; ces radicaux étant substitués par du fluor, du chlore, du brome dont les indices a, a', b, b', c, c' sont des nombres entiers, positifs ou nuls ;

m, n, p désignent des nombres entiers, égaux ou supérieurs à zéro, un seul parmi les trois nombres m, n, p pouvant être égal à zéro.

2. Substance selon la revendication 1, caractérisée en ce qu'elle est un copolymère d'alkylacrylates substitués par du fluor et du brome (n = 0).

3. Substance selon la revendication 1, caractérisée en ce qu'elle est un copolymère d'alkylacrylates substitués par du chlore et du brome (m = 0).

4. Substance selon la revendication 1, caractérisée en ce qu'elle est un terpolymère d'alkylacrylates substitués par du fluor, du chlore et du brome (m, n, p ≠ 0).

5. Substance selon la revendication 1, caractérisée en ce qu'elle est un copolymère d'α-(halogénoalkyl) acrylates d'alkyle ou d'halogénoalkyle substitués par du fluor et du brome (n = 0).

6. Substance selon la revendication 1, caractérisée en ce qu'elle est un copolymère d'α-(halogénoalkyl) acrylates d'alkyle ou d'halogénoalkyle substitués par du chlore et du brome (m = 0).

7. Substance selon la revendication 1, caractérisée en ce qu'elle est un terpolymère d'α-(halogénoalkyl) acrylates d'alkyle ou d'halogénoalkyle substitués par du fluor, du chlore et du brome (m, n, p ≠ 0).

8. Procédé de fabrication d'une substance de photomasquage consistant à effectuer une copolymérisation, de type radicalaire, par chauffage d'au moins deux types de monomères en présence de catalyseurs de polymérisation caractérisé en ce qu'on utilise des monomères dérivables des unités récurrentes constituant la formule de la revendication 1.

9. Photomasque dégradable sous l'action de l'un des rayonnements suivants : gamma, X, ultraviolet, électrons, obtenu à l'aide d'un composé de photomasquage, caractérisé en ce qu'il est obtenu à l'aide d'une substance de photomasquage selon l'une quelconque des revendications 1 à 7.

## Claims

1. A photomasking composition which is degradable by radiation, characterised by being formed from α-alkylacrylate copolymers which are substituted at least by two types of halogen atoms and which have the following general formula

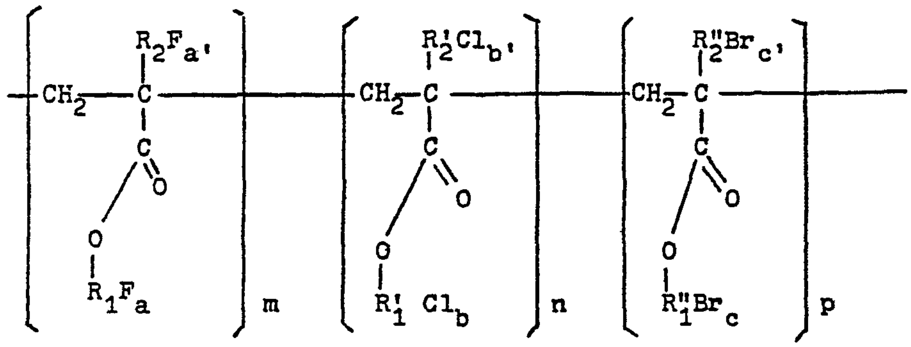

wherein

$R_1$, $R'_1$, $R''_1$, $R_2$, $R'_2$, $R''_2$ represent alkyl groups having 1 to 10 carbon atoms in the fundamental chain which are substituted by either fluorine, chlorine or bromine, wherein the indices a, a', b, b', c, c' are either zero or a positive integer;

and m, n, p are either zero or positive integers, wherein only one of the numbers m, n or p may be zero.

2. A composition according to claim 1, characterised in that it is an alkylacrylate copolymer that is substituted by fluorine and bromine ($n = 0$).

3. A composition according to claim 1, characterised in that it is an alkylacrylate copolymer that is substituted by chlorine and by bromine ($m = 0$).

4. A composition according to claim 1, characterised in that it is an alkylacrylate terpolymer that is substituted by fluorine, chlorine and bromine ($m, n, p \neq 0$).

5. A composition according to claim 1, characterised in that it is an alkyl or a haloalkyl-α(haloalkyl) acrylate copolymer that is substituted by fluorine and bromine ($n = 0$).

6. A composition according to claim 1, characterised in that it is an alkyl or a haloalkyl-α(haloalkyl) acrylate copolymer that is substituted by chlorine and bromine ($m = 0$).

7. A composition according to claim 1, characterised in that it is an alkyl or haloalkyl-α(haloalkyl) acrylate terpolymer that is substituted by fluorine, chlorine and bromine ($m, n, p \neq 0$).

8. A process for preparing a photomasking composition by radical polymerisation through heating at least two kinds of monomers in the presence of polymerisation catalysts, characterised by using such monomers as are derived from the recurrent units constituting the formula of claim 1.

9. A photomask which may be degraded by the action of the following types of radiation : gamma, X-, ultraviolet and electron radiation, and which is obtained by the aid of a photomasking composition, characterised in that it may be obtained by the aid of a photomasking composition as claimed in any of the claims 1 to 7.

## Ansprüche

1. Durch Bestrahlung abbaubare Fotomaskierungssubstanz, dadurch gekennzeichnet, daß sie aus α-Alkylacrylat-Mischpolymerisaten aufgebaut ist, die mindestens durch zwei Arten von Halogenatomen substituiert sind und die folgende allgemeine Formel aufweisen

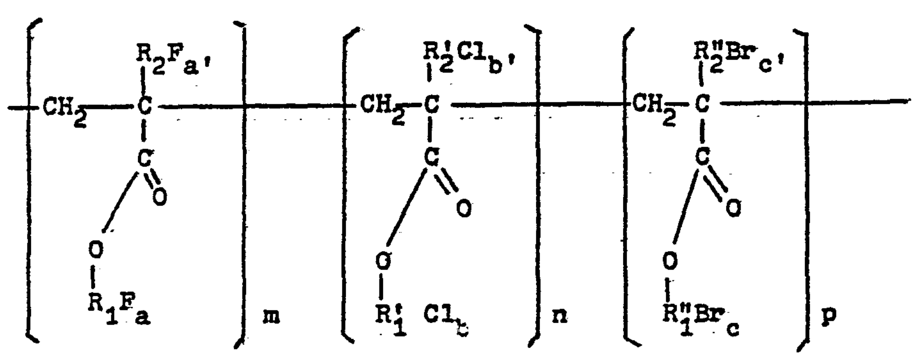

worin

$R_1$, $R'_1$, $R''_1$, $R_2$, $R'_2$, $R''_2$ Alkylreste mit 1 bis 10 Kohlenstoffatomen in der Hauptkette, die durch Fluor, Chlor oder Brom substituiert sind, bedeuten, wobei die Indizes a, a', b, b', c, c' Null oder eine ganze positive Zahl bedeuten ;

und m, n, p Null oder ganze positive Zahlen bedeuten, wobei nur eine der Zahlen m, n oder p gleich Null sein kann.

2. Substanz gemäß Anspruch 1, dadurch gekennzeichnet, daß sie ein Alkylacrylat-Mischpolymerisat ist, das durch Fluor und Brom substituiert ist ($n = 0$).

3. Substanz gemäß Anspruch 1, dadurch gekennzeichnet, daß sie ein Alkylacrylat-Mischpolymerisat ist, das durch Chlor und durch Brom substituiert ist ($m = 0$).

4. Substanz gemäß Anspruch 1, dadurch gekennzeichnet, daß sie ein Alkylacrylat-Terpolymerisat ist, das durch Fluor, Chlor und Brom substituiert ist ($m, n, p \neq 0$).

5. Substanz gemäß Anspruch 1, dadurch gekennzeichnet, daß sie ein Alkyl- oder Halogenalkyl-α-(halogenalkyl)-acrylat-Mischpolymerisat ist, das durch Fluor und Brom substituiert ist ($n = 0$).

6. Substanz gemäß Anspruch 1, dadurch gekennzeichnet, daß sie ein Alkyl- oder Halogenalkyl-α-(halogenalkyl)-acrylat-Mischpolymerisat ist, das durch Chlor und Brom substituiert ist ($m = 0$).

7. Substanz gemäß Anspruch 1, dadurch gekennzeichnet, daß sie ein Alkyl- oder Halogenalkyl-α-(halogenalkyl)-acrylat-Terpolymerisat ist, das durch Fluor, Chlor und Brom substituiert ist ($m, n, p \neq 0$).

8. Verfahren zur Herstellung einer Fotomaskierungssubstanz durch radikalische Mischpolymerisation durch Erhitzen mindestenz zweier Monomerenarten in Gegenwart von Polymerisationskatalysatoren, dadurch gekennzeichnet, daß man als Monomere solche verwendet, die sich von den wiederkehrenden Einheiten der in Anspruch 1 angegebenen Formel ableiten.

9. Fotomaske, die sich durch Einwirkung folgender Strahlungen abbauen läßt : Gamma-, Röntgen-, Ultraviolett- und Elektronenstrahlung und die mit Hilfe einer Fotomaskierungssubstanz erhältlich ist, dadurch gekennzeichnet, daß sie mit Hilfe einer Fotomaskierungssubstanz gemäß einem der Ansprüche 1 bis 7 erhältlich ist.

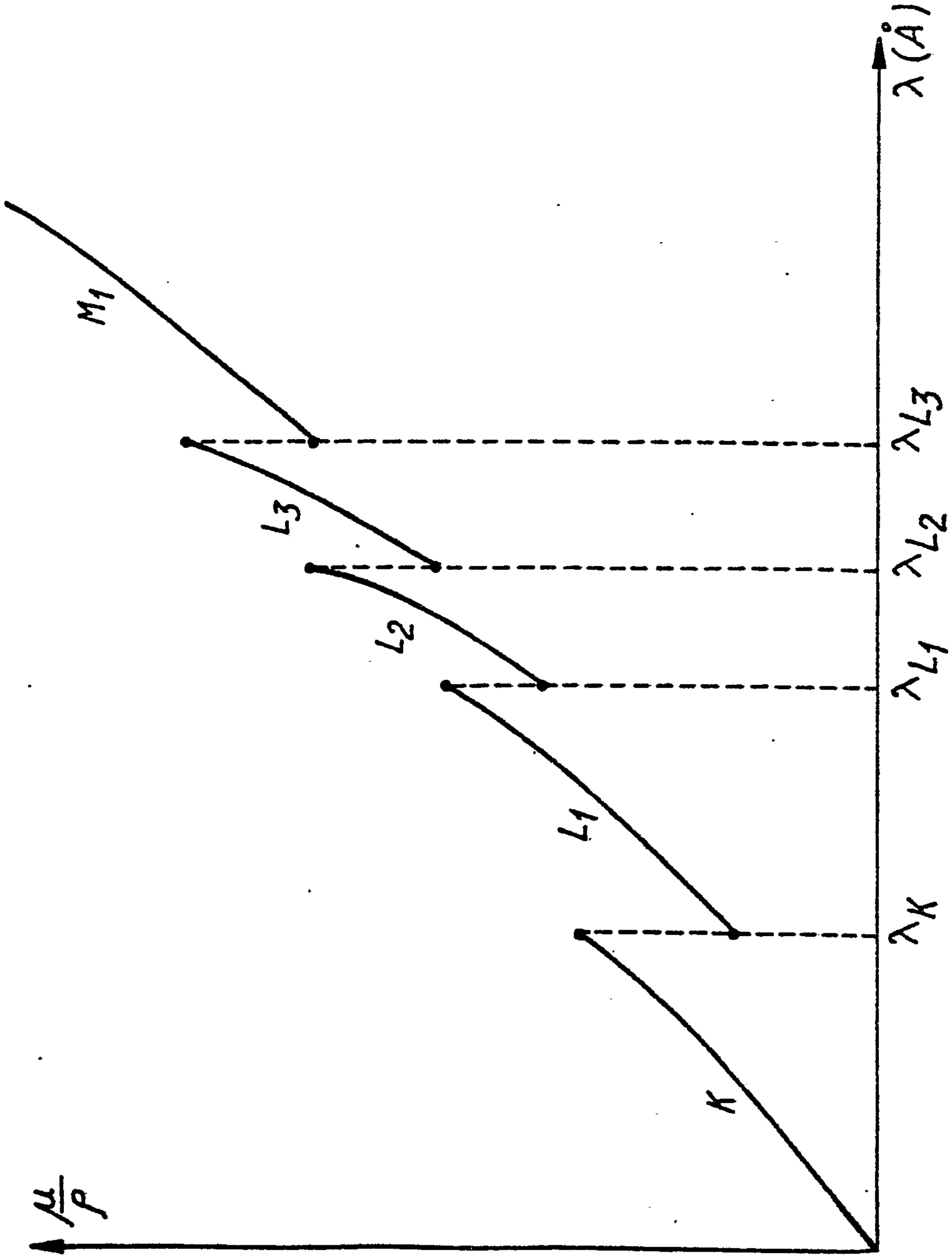
$\mu/\rho$
$\lambda$ (Å)
K
$L_1$
$L_2$
$L_3$
$M_1$
$\lambda_K$
$\lambda_{L_1}$
$\lambda_{L_2}$
$\lambda_{L_3}$